# EUROPEAN PATENT APPLICATION

(11) **EP 1 811 521 A1**
(43) Date of publication of application: **25.07.2007**
(21) Application number: 06077287.8
(22) Date of filing: 21.12.2006
(51) Int. Cl.: G11B 20/14, H03M 5/14

(54) **Viterbi decoding method and viterbi decoder**

(30) Priority: 24.01.2006 KR 20060007250
(71) Applicant: Samsung Electronics Co., Ltd., Yeongtong-gu Suwon-si, Gyeonggi-do (KR)
(72) Inventor: Park, Hyun-soo, Seoul (KR)
(74) Representative: D'Halleweyn, Nele Veerle Trees Gertrudis

(57) **Abstract**

A Viterbi decoding method and a Viterbi decoder for high density recording, in which at least one of states and/or branches exceeding a maximum run length are removed from the trellis when the maximum run length exists in a Viterbi decoding system. The constraint length is made larger than the maximum run length, preferably larger by one.

## Description

### CROSS-REFERENCE TO RELATED APPLICATIONS

This application claims the benefit of Korean Patent Application No. 10-2006-0007250, filed on January 24, 2006, in the Korean Intellectual Property Office, the disclosure of which is incorporated herein by reference.

### BACKGROUND OF THE INVENTION

### 1. Field of the Invention

An aspect of the present invention relates to a Viterbi decoding method and a Viterbi decoder.

### 2. Description of the Related Art

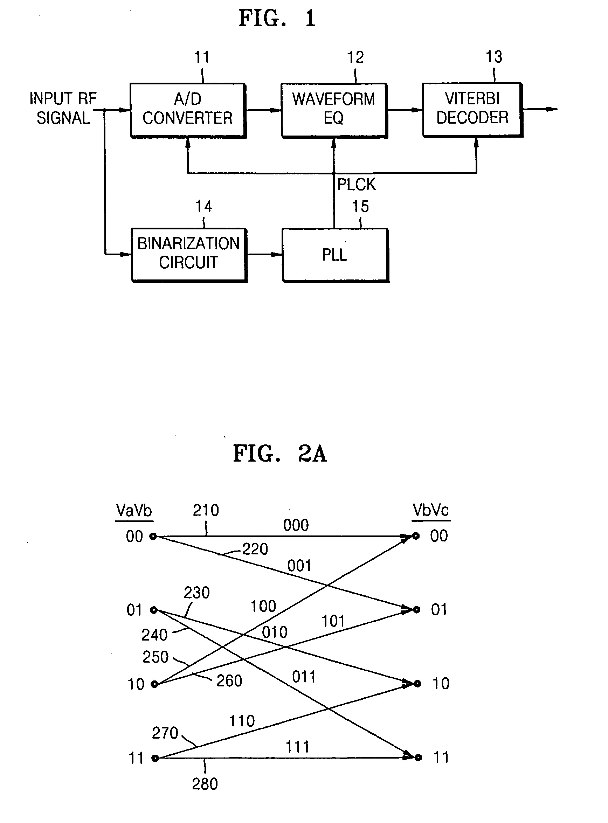

In an optical disk system, binary data recorded on an optical disk is reproduced by illuminating the disk using laser beams and detecting reflected waves. In general, signals read from the disk are RF (radio frequency) signals. The RF signal read from the disk is not a digital signal but an analog signal due to physical and optical characteristics of the disk. Therefore, a binarization process and a PLL (phase lock loop) process are necessary for converting an analog signal to a digital signal. Among various binarization apparatuses, a Viterbi decoder is known to be able to obtain the least erroneous binary signals. FIG. 1 is a block diagram of a conventional digital detector including a Viterbi decoder 13. The Viterbi decoder is able to detect a binary signal under optimal conditions suitable for channel characteristics. The Viterbi decoder performs better than a simple signal detection circuit or a run-length-correction decoder. A Finite Impulse Response (FIR) filter is used to obtain better detection performance so as to receive an optimal signal as an input of the Viterbi decoder. The FIR filter can be referred to as an equalizer (EQ) used to optimize the channel characteristics. Referring to FIG. 1, an RF signal read from an optical disk is input to a binarization circuit 14 and an A/D converter 11. The binarization circuit 14 binarizes the RF signal and outputs the binarized RF signal to a PLL 15. The PLL 15 generates a clock signal synchronized with the RF signal based on binarized data, and outputs the clock signal to the A/D converter 11, a waveform EQ 12, and the Viterbi decoder 13. The AID converter 11 converts the RF signal from an analog signal to a digital signal and outputs the digital data to the waveform EQ 12. The waveform EQ 12 performs waveform equalization on the digital data suitable for the Viterbi decoder 13. The Viterbi decoder 13 Viterbi-decodes the waveform-equalized data and outputs a regeneration signal. The Viterbi decoding can restore an RF signal damaged due to mixed noise on a channel, and is widely used in a HDD.

As the recording density of the optical disk increases, quality of the regeneration signal deteriorates, which causes erroneous operation. To address this problem, the Viterbi decoder 13 has a high number of taps corresponding to the increase in the recording density. However, the higher the number of taps in the Viterbi decoder 13, the larger the size of the hardware and the slower the operational speed of the Viterbi decoder.

The Viterbi decoder 13 is used to obtain optimal binary data using statistical characteristics of an input signal. To form the Viterbi decoder 13, a level suitable for the input signal must be defined and the statistical characteristics of the input signal must be determined according to the level, so that the least erroneous binary signals can be obtained.

The structure of the Viterbi decoder 13 depends on the number of taps. For example, a Viterbi decoder including three taps can have optimal decoding performance with regard to three input signals.

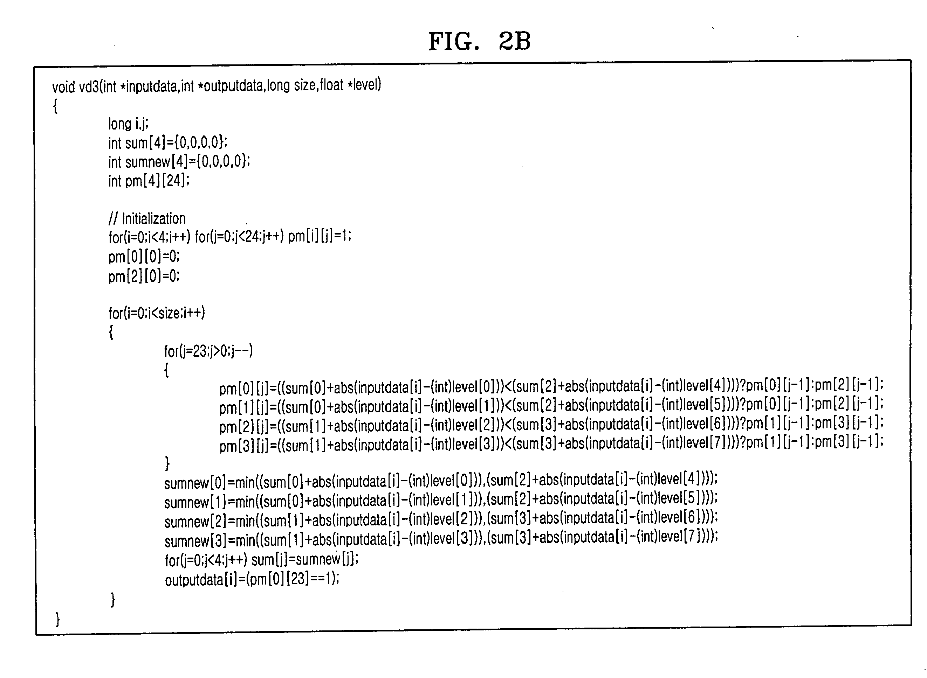

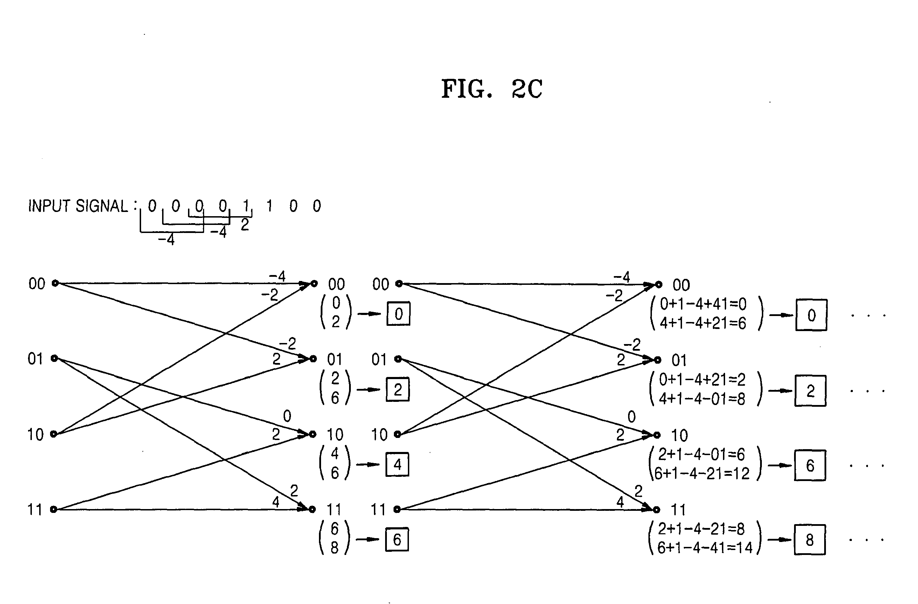

FIG. 2A is a trellis diagram of a conventional Viterbi decoder including three taps. FIG. 2B illustrates the trellis diagram illustrated in FIG. 2A implemented in C language code. The conventional Viterbi decoder including three taps is generally used.

Referring to FIG. 2A, the trellis diagram includes a previous state VaVb, a next state VbVc, and eight levels related to both states. Two binary input signals (for convenience, sequentially received input signals Va and Vb) can be expressed as four levels. If an input signal Vc is additionally received, Vb and Vc are expressed as four levels. Four levels of the previous state Va and Vb are changed to the next state Vb and Vc, and thus expressed as eight levels (states) using Va, Vb, and Vc. The eight levels are 000 210, 001 220, 010 230, 011 240, 100 250, 101 260, 110 270, and 111 280. Using a C algorithm as shown in FIG. 2B, a parameter sum having an erroneous accumulative value of the previous state is used to calculate a parameter sumnew having an erroneous accumulative value of the next state. The parameter sumnew is obtained by adding erroneous accumulative values newly generated from the erroneous accumulative value of the previous state. A smaller value between two available values is selected.

For example, when Vb, Vc are 0, 0, data of the previous state 0, 0 is transited 210 and data of 1, 0 is transited 250. When the data of 0, 0 is transited, a new error value defined in level 000 (level 0) is added. When the data of 1, 0 is transited, a new error value defined in level 100 (level 4) is added. A smaller value between the two added values is selected.

This calculation corresponds to sumnew[0]=min((sum(0)+abs(inputdata[i]-(int)level[0])),(sum[2]+abs(inputdata[i]-(int)level[4]))); of the C algorithm of FIG. 2B.

For reference, min function selects a smaller value between two factors and outputs the selected smaller value.

Also, information on a selected signal is stored in a path memory (PM), which stores final information including accumulated least error values. Therefore, since information on a path including the least error value after a predetermined section is selected as a final output, a signal having an optimal state can be decoded. Thus, an input signal and levels suitable for each of operations must be provided to operate the Viterbi decoder.

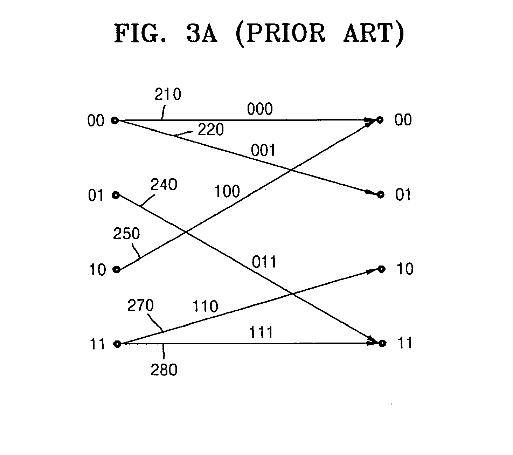

If a run length limited code is used in a system, an algorithm of the Viterbi decoder is changed. For example, when a code 1, 7 has a shortest T (T denotes a basic period for generating a code) which is not a 1T signal but a 2R signal (that is, the smallest T is 2T and the largest T is 8T), since 1 T in which Va, Vb, Vc are 1, 0, 1 or 0, 1, 0 does not appear, the level 101 260 and the level 010 230 do not appear. In this case, the Viterbi decoder including three taps must be corrected as illustrated in FIG. 3A, which is a trellis diagram of a conventional Viterbi decoder including three taps for a 1, 7 code. Referring to FIG. 3A, the level 230 and the level 260 are removed from the trellis diagram.

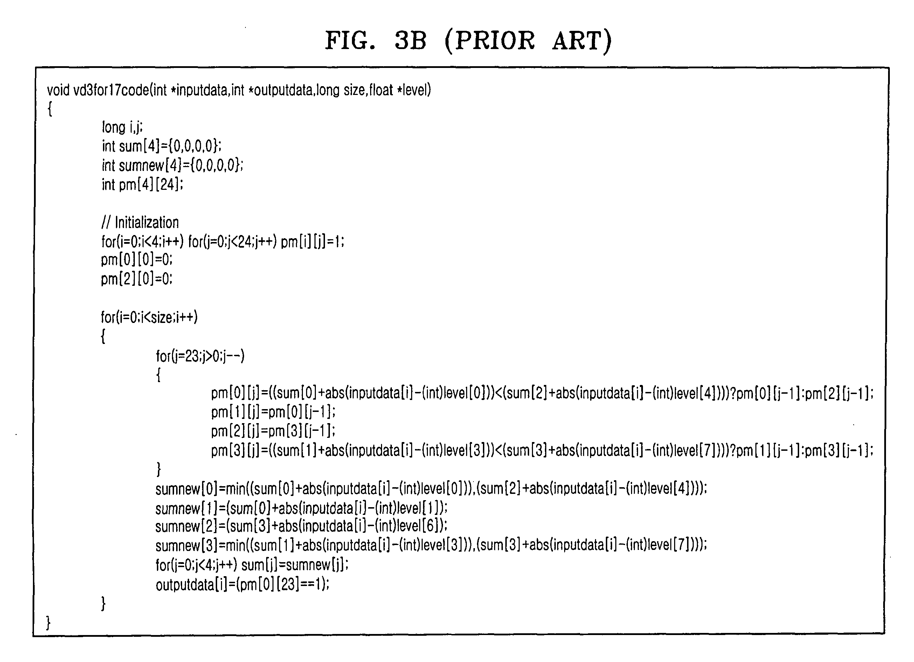

A minimum run length is usually limited to more than a predetermined length in optical disks. In this case, a method of removing a part that is not used corresponding to the minimum run length from the trellis diagram and accordingly reducing the size of a circuit has been suggested. Therefore, the structure illustrated in FIG. 3A and the algorithm illustrated in FIG. 3B are widely used in Viterbi decoders.

Conventional optical disks do not consider a maximum run length since the maximum run length is too long compared to the number of taps included in the Viterbi decoder. Referring to FIG. 3A, the Viterbi decoder includes three taps and 8 as the maximum run length. It is not necessary to consider a large value corresponding to the maximum run length. The number of taps indicates a number of a level. The number of the level is 3 and the number of taps is 3.

However, since the recording density increases, a unit length which belongs to the distribution of a laser light source is shorter. In this case, the size of a signal which is reflected and returned is reduced, which increases mutual interference. To address the problem of mutual interference, the number of taps of the Viterbi decoder is generally increased. However, hardware structure is more complex and the operational speed of the hardware is slower due to the increased number of taps. Therefore, it is necessary to optimize the structure and speed of hardware based on the number of used taps.

### SUMMARY OF THE INVENTION

An aspect of the present invention provides a Viterbi decoding method and a Viterbi decoder capable of reducing the size of a hardware circuit and increasing the operation speed of hardware using a method of designing optimal hardware according to a limited code when a maximum run length is limited.

According to an aspect of the present invention, there is provided a Viterbi decoder in which at least one of nodes and transit states exceeding a maximum run length is removed in a Viterbi decoding system in which the maximum run length is limited to K and taps more than K+1 are used.

According to another aspect of the present invention, there is provided a Viterbi decoder that uses taps whose number exceeds a maximum run length including a branch metric calculation unit calculating an absolute value of a difference between an input signal and a reference level; an addition comparison and selection unit adding a branch metric generated by the branch metric calculation unit to a previously stored state metric, calculating new state metrics, selecting a smallest state metric from the new state metrics, and determining a retaining path; and a path memory storing a retaining path determined by the addition comparison and selection unit, wherein the branch metric calculation unit and the addition comparison and selection unit do not perform at least one of calculations corresponding to nodes and transit states which exceed a maximum run length.

According to another aspect of the present invention, the maximum run length is 9, the Viterbi decoder includes 10 taps, and the branch metric calculation unit and the addition comparison and selection unit do not perform at least one of calculations corresponding to nodes and transit states which exceed the maximum run length.

According to another aspect of the present invention, the maximum run length is 13, the Viterbi decoder includes 14 taps, and the branch metric calculation unit and the addition comparison and selection unit do not perform at least one of calculations corresponding to nodes and transit states which exceed the maximum run length.

According to another aspect of the present invention, there is provided a Viterbi decoding method including: performing Viterbi decoding by removing at least one of nodes and transit states exceeding a maximum run length in a Viterbi decoding system in which the maximum run length is limited to K and taps exceeding K+1 are used.

According to still another aspect of the present invention, there is provided a Viterbi decoding method that uses taps whose number exceeds a maximum run length including: a branch metric calculating operation of calculating an absolute value of a difference between an input signal and a reference level; an addition comparing and selecting operation of adding a branch metric generated from the branch metric calculating operation to a previously stored state metric, calculating new state metrics, selecting a smallest state metric from the new state metrics, and determining a retaining path; and storing a retaining path determined by the addition comparison and selection unit, wherein, in the branch metric calculating operation and the addition comparing and selecting operation, at least one of calculations corresponding to nodes and transit states which exceed a maximum run length is not performed.

Additional aspects and/or advantages of the invention will be set forth in part in the description which follows and, in part, will be obvious from the description, or may be learned by practice of the invention.

### BRIEF DESCRIPTION OF THE DRAWINGS

These and/or other aspects and advantages of the invention will become apparent and more readily appreciated from the following description of the embodiments, taken in conjunction with the accompanying drawings of which:
FIG. 1 is a block diagram of a conventional digital detector including a Viterbi decoder;
FIG. 2A is a trellis diagram of a conventional Viterbi decoder including three taps;
FIG. 2B illustrates the trellis diagram illustrated in FIG. 2A implemented in C language code;
FIG. 3A is a trellis diagram of a conventional Viterbi decoder including three taps for a (1, 7) code;
FIG. 3B illustrates the trellis diagram illustrated in FIG. 3A implemented in C language code;
FIG. 4A is a trellis diagram of a Viterbi decoder including three taps for a (1,7) code in which a maximum run length is limited to 2T according to an embodiment of the present invention;
FIG. 4B illustrates the trellis diagram illustrated in FIG. 4A implemented in C language code;
FIG. 5A is a trellis diagram of a Viterbi decoder including five taps according to an embodiment of the present invention;
FIG. 5B illustrates the trellis diagram illustrated in FIG. 5A implemented in C language code;
FIG. 6A is a trellis diagram of a Vterbi decoder including five taps for the (1,7) code according to an embodiment of the present invention;
FIG. 6B illustrates the trellis diagram illustrated in FIG. 6A implemented in C language code;
FIG. 7A is a trellis diagram of a Viterbi decoder in which a minimum run length is limited to 2 and a maximum run length is limited to 3 according to an embodiment of the present invention; and
FIG. 8 is a block diagram of a Viterbi decoder according to an embodiment of the present invention.

### DETAILED DESCRIPTION OF THE EMBODIMENTS

Reference will now be made in detail to the present embodiments of the present invention, examples of which are illustrated in the accompanying drawings, wherein like reference numerals refer to the like elements throughout. The embodiments are described below in order to explain the present invention by referring to the figures.

According to an aspect of the present invention, when the number of taps included in a Viterbi decoder is greater than a maximum run length, an algorithm can be used as described below.

A trellis diagram illustrating an n-tap Viterbi decoder includes a previous state of n-1 nodes and a current state of n-1 nodes caused by a new input. The n-1 nodes connect to each other through a total number of n transit states. Each of the n-1 nodes and the n transit states can be expressed as a binary number.

One of the binary n-1 nodes which is greater than the maximum run length cannot appear due to run length limit conditions and thus is removed. Also, one of the binary n transit states which is greater than the maximum run length cannot appear due to the run length limit conditions and thus is removed. When the number of taps included in the Viterbi decoder is greater than the maximum run length, an embodiment of the present invention forms a circuit by removing a node greater than the maximum run length, a transit state greater than the maximum run length, or both the node and transit state greater than the maximum run length, thereby reducing the size of the Viterbi decoder hardware.

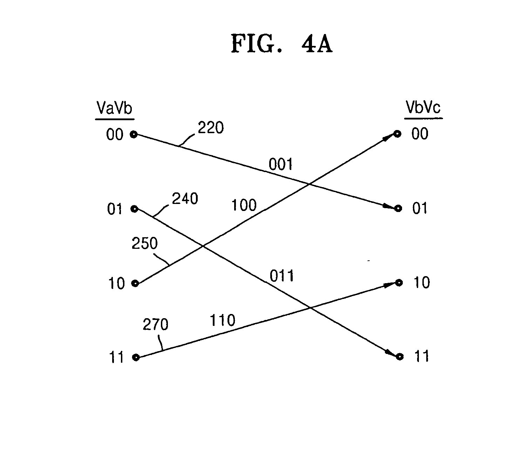

FIG. 4A is a trellis diagram of a Viterbi decoder including three taps for a (1,7) code in which a maximum run length is limited to 2T according to an embodiment of the present invention.

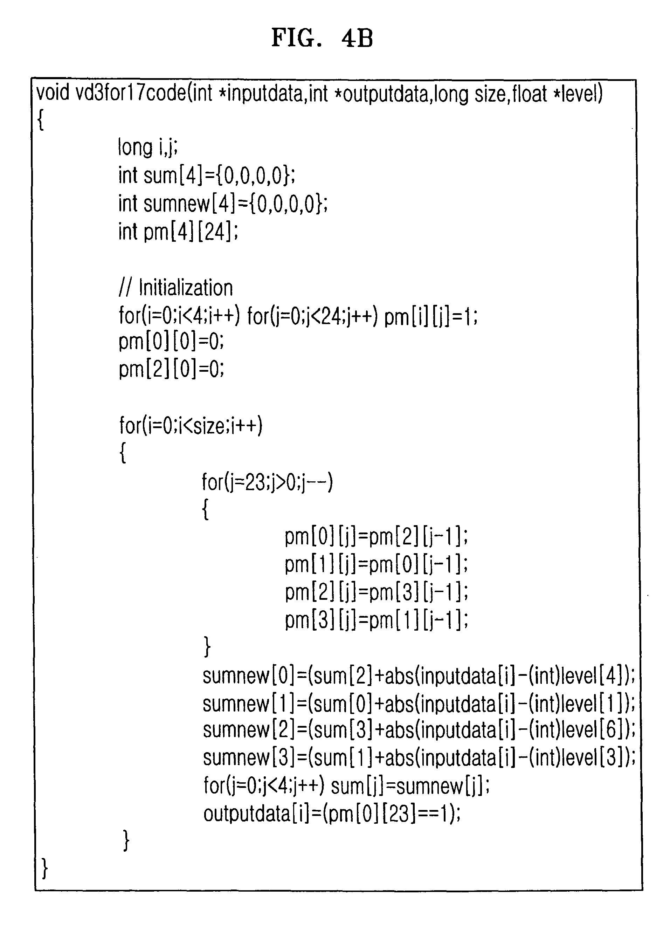

With respect to the conventional Viterbi decoder including three taps for the (1,7) code illustrated in FIG. 3A, if the maximum run length is limited to 2T, i.e., 3T does not appear and no node is removed. However, since arrows 000 (210) and 111 (280) indicating a state transit cannot appear due to conditions of a code, a method according to an aspect of the present invention is used to form a circuit as illustrated in FIGS. 4A and 4B.

FIG. 4B illustrates the trellis diagram illustrated in FIG. 4A implemented in C language code. Referring to FIGS. 3B and 4B, absolute value calculations corresponding to level [0] and level [7] of sumnew [0] and sumnew [3] are removed and thus a calculation for obtaining a min value is removed from the sumnew [0] and sumnew [3]. Further, operation regarding path memory is simple.

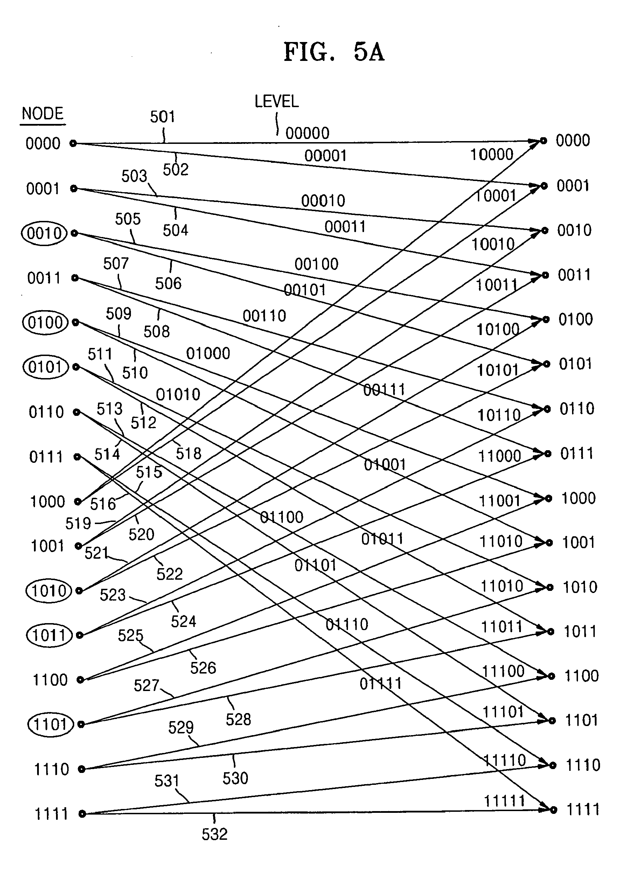

A Viterbi decoder with a complex structure can be used in order to obtain better performance. The Viterbi decoder with the complex structure can be obtained by increasing the number of taps. A Viterbi decoder including five taps, a Viterbi decoder including five taps for the (1,7) code, and a Viterbi decoder including five taps for the (1,7) code in which the maximum run length is limited according to an embodiment of the present invention are illustrated in FIGS. 5A through 7A.

FIG. 5A is a trellis diagram of the Viterbi decoder including five taps according to an embodiment of the present invention. Referring to FIG. 5A, 16 previous nodes from 0000 to 1111 and 32 levels 501 through 532 in which each of the 16 previous nodes corresponds to two levels exist.

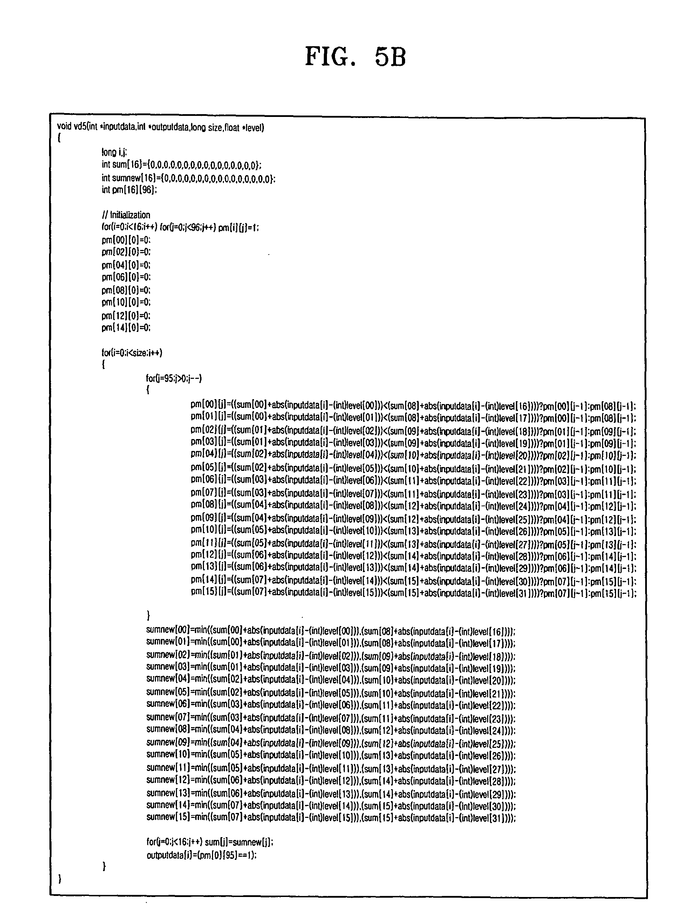

FIG. 5B illustrates the trellis diagram illustrated in FIG. 5A implemented in C language code.

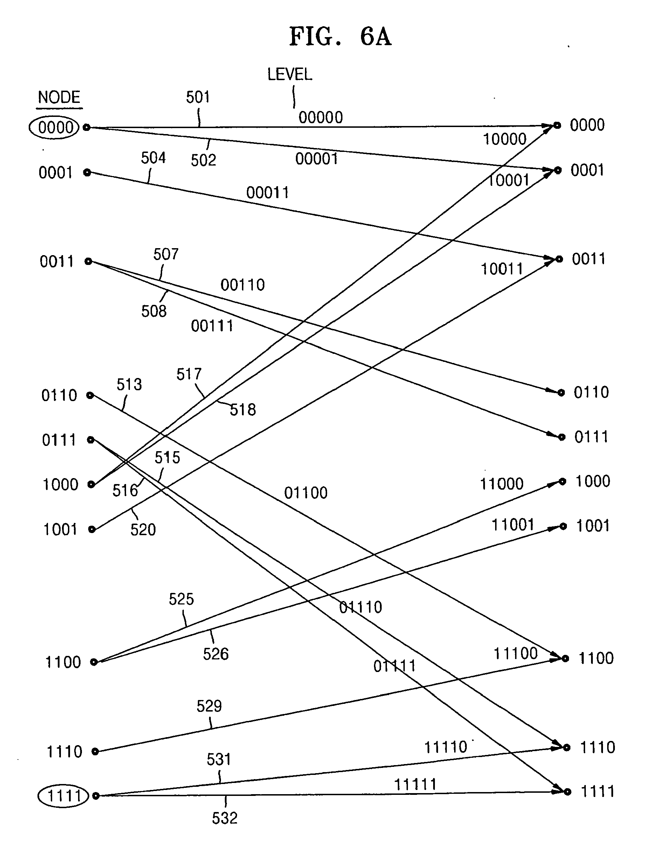

FIG. 6A is a trellis diagram of the Viterbi decoder including five taps for the (1,7) code according to an embodiment of the present invention. Referring to FIG. 6A, a node and a level corresponding to 1T are removed according to the condition of the (1,7) code. In detail, nodes including 1T 0010, 0100, 0101, 1010, 1011, and 1102 are removed. Also, levels including 1T 503, 505, 506, 509 through 512, 514, 519, 521 through 524, 527, 528, and 530 are removed.

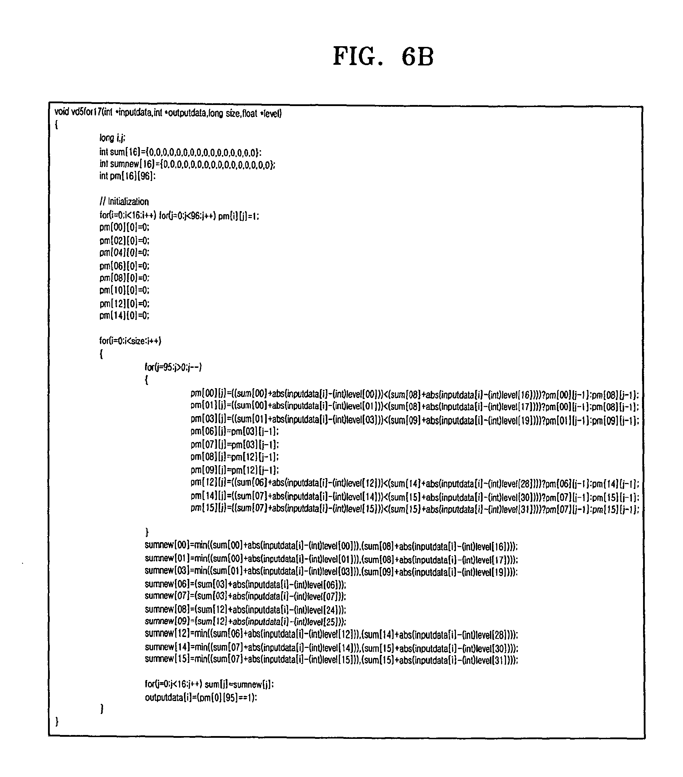

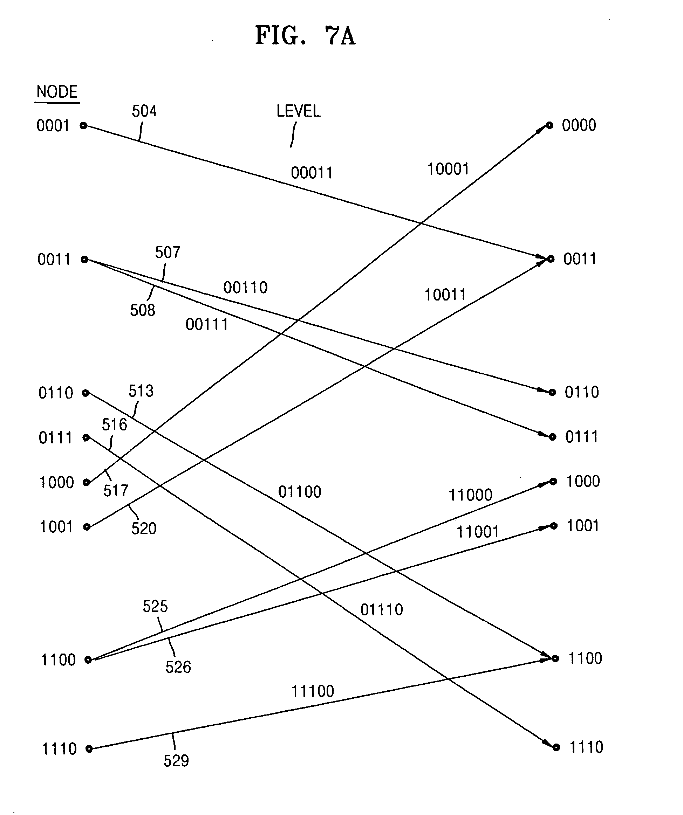

FIG. 6B illustrates the trellis diagram illustrated in FIG. 6A implemented in C language code. Referring to FIG. 6B, calculations corresponding to the nodes including 1T sumnew[2], sumnew[4], sumnew[5], sumnew[10], sumnew[11], and sumnew[13] are removed. Calculations including those of level [8], level [9], level [22], and level [23] relating to the levels including 1T sumnew[6], sumnew[7], sumnew[8], and sumnew[9] are removed. In this regard, if the maximum run length is limited to not 8T but 3T, since Ts more than 4T cannot appear, nodes 0000 and 1111 are removed and levels including 0000 and 1111 are removed, which results in a Viterbi decoder as illustrated in FIG 7A.

FIG. 7A is a trellis diagram of a Viterbi decoder in which a minimum run length is limited to 2 and the maximum run length is limited to 3 according to an embodiment of the present invention. Referring to FIG. 7A, nodes 0000 and 1111 indicating 4T are removed, and levels including 4T 00000(501), 00001 (502), 10000(517), 01111(529), 11110(531), 11111 (532) are removed.

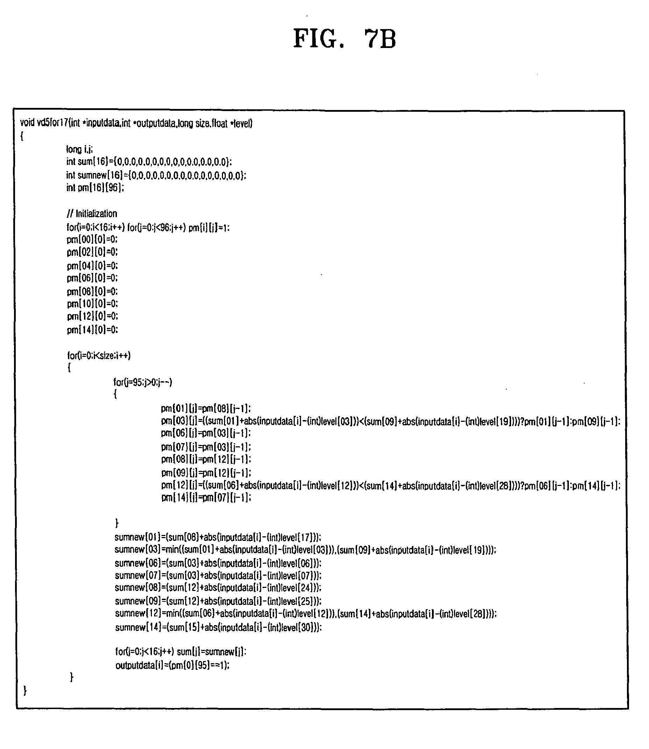

FIG. 7B illustrates the trellis diagram illustrated in FIG. 7A implemented in C language code. Referring to FIG. 7B, calculations corresponding to nodes including 4T sumnew[0] and sumnew[15] are removed, and calculations of level[1] and level[14] relating to levels including 4T sumnew[1] and sumnew[14] are removed.

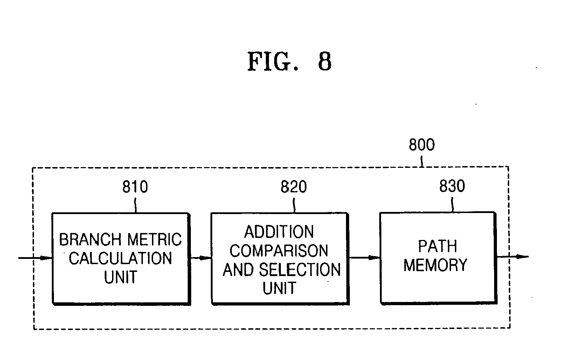

FIG. 8 is a block diagram of a Viterbi decoder 800 according to an embodiment of the present invention. Referring to FIG. 8, the Viterbi decoder 800 includes a branch metric calculation unit 810, an addition comparison and selection unit 820, and a path memory 830.

The branch metric calculation unit 810 calculates a branch metric which is an absolute value of a difference between an input signal and a plurality of reference levels for input data symbols. Since a node and level greater than the maximum run length are removed, the branch metric calculation unit 810 does not include a circuit corresponding to the node greater than the maximum run length, and does not perform a calculation using the node and the level greater than the maximum run length abs(inputdata[i]-(int)level[]) of the code illustrated in FIG. 4B is a calculation performed by the branch metric calculation unit 810, i.e., calculation for obtaining the absolute value of the difference between the input data and the level. Unlike the codes illustrated in FIGS. 3B and 4B, calculations for abs(inputdata[i]-(int)level[0]) and abs(inputdata[i]-(int)level[7])are removed.

The addition comparison and selection unit 820 adds the branch metric generated by the branch metric calculation unit 810 to a previously stored state metric, calculates new state metrics, selects the smallest state metric from the new state metrics, and determines a retaining path. In particular, since the node and level greater than the maximum run length are removed according to the present embodiment of the invention, the addition comparison and selection unit 820 does not perform a calculation of a state metric relating to the node and level greater than the maximum run length. min((sum[]+abs(inputdata[i]-(int))eve)[]). (sum[]+abs(inputdata[i]-(int)level[]))) of the code illustrated in FIG. 4 is a calculation performed by the addition comparison and selection unit 820, i.e., the calculation for obtaining the smallest state metric by adding a previous state metric sum to the absolute value of the difference between the branch metric, i.e., the input data, and level. Therefore, unlike the codes illustrated in FIGS. 3B and 4B, since calculations for abs(inputdata[i]-(int)level[0]) and abs(inputdata[i]-(int)level[7]) of nodes 0 and 3 are removed, it is not necessary to calculate the smallest value of sum[0]+abs(inputdata[i]-(int)level[0]) and sum[2]+abs(inputdata[i]-(int)level[4] of node 0 and the smallest value of sum[1]+abs(inputdata[i]-(int)level[3]) and sum[3]+abs(inputdata[i]-(int)level[7] of node 3.

The path memory 830 stores an output signal corresponding to the retaining path determined by the addition comparison and selection unit 820 and outputs the signal.

An aspect of the present invention can also be embodied as computer readable code on a computer readable recording medium. The computer readable recording medium is any data storage device that can store data which can be thereafter read by a computer system. Examples of the computer readable recording medium include read-only memory (ROM), random-access memory (RAM), CD-ROMs, magnetic tapes, floppy disks, optical data storage devices, and carrier waves (e.g., transmission through the Internet). The computer readable recording medium can also be distributed through a network coupled computer system so that the computer readable code is stored and executed in a distributed fashion.

According to another aspect of the present invention, a Viterbi decoder with the condition of a maximum run length reduces the size of hardware and thus the size of a selection circuit, increases operational speed, and reduces errors since an output signal which does not comply with the maximum run length is not produced.

In a system that uses a (1,7) code, a Viterbi decoder including more than nine taps can be applied to an aspect of the present invention. In a system that uses a (2,10) code, a Viterbi decoder including more than twelve taps can also be applied to an aspect of the present invention.

## Claims

1. A Viterbi decoder that uses taps whose number exceeds a maximum run length comprising:
a branch metric calculation unit calculating an absolute value of a difference between an input signal and a reference level;
an addition comparison and selection unit adding a branch metric generated by the branch metric calculation unit to a previously stored state metric, calculating new state metrics, selecting a smallest state metric from the new state metrics, and determining a retaining path; and
a path memory storing the retaining path determined by the addition comparison and selection unit,
wherein the branch metric calculation unit and the addition comparison and selection unit do not perform at least one of calculations corresponding to nodes and transit states which exceed a maximum run length.

2. The Viterbi decoder of claim 1, wherein when the maximum run length is 9 and the Viterbi decoder comprises 10 taps, the branch metric calculation unit and the addition comparison and selection unit do not perform at least one of calculations corresponding to nodes and transit states which exceed the maximum run length.

3. The Viterbi decoder of claim 1, wherein when the maximum run length is 13 and the Viterbi decoder comprises 14 taps, the branch metric calculation unit and the addition comparison and selection unit do not perform at least one of calculations corresponding to nodes and transit states which exceed the maximum run length.

4. A Viterbi decoding method comprising:
performing Viterbi decoding by removing at least one of nodes and transit states exceeding a maximum run length in a Viterbi decoding system in which the maximum run length is limited to K and more than K+1 taps are used.

5. A Viterbi decoding method that uses taps whose number exceeds a maximum run length comprising:
a branch metric calculating operation calculating an absolute value of a difference between an input signal and a reference level;
an addition comparing and selecting operation adding a branch metric generated from the branch metric calculating operation to a previously stored state metric, calculating new state metrics, selecting a smallest state metric from the new state metrics, and determining a retaining path; and
storing the retaining path determined by the addition comparison and selection unit,
wherein, in the branch metric calculating operation and the addition comparing and selecting operation, at least one of calculations corresponding to nodes and transit states which exceed a maximum run length is not performed.

6. The Viterbi decoding method of claim 5, wherein when the maximum run length is 9 and the Viterbi decoder comprises 10 taps, at least one of calculations corresponding to nodes and transit states which exceed the maximum run length is not performed in the branch metric calculating operation and the addition comparing and selecting operation.

7. The Viterbi decoding method of claim 5, wherein when the maximum run length is 13 and the Viterbi decoder comprises 14 taps, at least one of calculations corresponding to nodes and transit states which exceed the maximum run length is not performed in the branch metric calculating operation and the addition comparing and selecting operation.

8. A Viterbi decoder comprising:
a plurality of taps, wherein when the number of taps included in the Viterbi decoder is greater than a maximum run length, a node greater than the maximum run length is removed.

9. A Viterbi decoder comprising:
a plurality of taps, wherein when the number of taps included in the Viterbi decoder is greater than a maximum run length, a transit state greater than the maxim run length is removed.
